# EUROPEAN PATENT APPLICATION

(11) **EP 0 570 069 A2**
(43) Date of publication of application: **18.11.1993**
(21) Application number: 93201334.5
(22) Date of filing: 07.05.1993
(51) Int. Cl.: H01L 23/485

(54) **Semiconductor device with a semiconductor body of which a surface is provided with a conductor pattern formed in a layer package comprising a TiW layer and an Al layer**

(30) Priority: 12.05.1992 EP 92201354
(71) Applicant: Philips Electronics N.V., 5621 BA Eindhoven (NL)
(72) Inventor: Wolters, Robertus Adrianus Maria, NL-5656 AA Eindhoven (NL); Swart, Edwin Tjibbe, NL-5656 AA Eindhoven (NL)
(74) Representative: Rensen, Jan Geert

(57) **Abstract**

A semiconductor device comprising a semiconductor body (1) with a surface (4) provided with an insulating layer (6) in which contact windows (7) are provided through which silicon regions (3, 5) situated below the insulating layer (6) are connected to a pattern of conductors (11) formed in a package (8, 9, 10) of layers provided on the insulating layer (6) and in the contact windows (7), which package comprises a barrier layer (8) of TiW with 10 to 30 at.% Ti, an intermediate layer (9) improving the barrier properties, and a top layer (10) comprising aluminium. According to the invention, the intermediate layer (9) improving the barrier properties is a layer of TiW which comprises nitrogen. The combination according to the invention of the barrier layer (8) with the intermediate layer (9) improving the barrier properties exhibits better barrier properties than does a barrier layer of TiW which has been exposed to air.

## Description

The invention relates to a semiconductor device comprising a semiconductor body with a surface provided with a insulating layer in which contact windows are provided through which silicon regions situated below the insulating layer are connected to a pattern of conductors formed in a layer pace provided on the insulating layer ad in the contact windows, which package comprises a barrier layer of TiW with 10 to 30 at. % Ti, a intermediate layer for improving the barrier properties, ad a top layer comprising aluminium.

The insulating layer is, for example, a layer of silicon oxide, silicon nitride, or silicon oxynitride. The silicon regions situated below the insulating layer may be regions of monocrystalline silicon or of polycrystalline silicon. These may in addition be provided with a metal silicide top layer. Monocrystalline regions are, for example, semiconductor regions provided in the semiconductor body, such as source ad drain regions of field effect transistors. Polycrystalline regions are, for example, contact regions of conductor tracks provided on the surface, such as the gate electrodes of field effect transistors, which are made of highly doped, conductive polycrystalline silicon. The top layer comprising aluminium may be of pure aluminium, but alternatively of aluminium to which up to a few percents of silicon or copper have been added.

A barrier layer of TiW is used between silicon ad aluminium conductor tracks in the manufacture of semiconductor devices with the purpose of counteracting reactions between silicon ad aluminium. Such reactions could occur during the subsequent manufacture of the semiconductor device during which the semiconductor body is heated several more times up to a comparatively high temperature.

A barrier layer of TiW is found in practice not to form a absolute barrier. Ti and W from the layer form chemical compounds with aluminium. Although the compounds with tungsten are formed less readily than those with titanium, ad accordingly a layer without titanium would actually be preferable, nevertheless 10 to 30 at.% titanium is added to the layer in practice. This is done to ensure that the layer has good adhesion to the subjacent substrate ad to ensure that the layer forms a low-ohmic contact with the subjacent silicon or metal silicide. It is also done, however, to ensure that the layer can be deposited by means of a practical sputter deposition process.

During a sputter deposition process, a slice of semiconductor material is positioned in a reaction chamber opposite a target of the material to be deposited, after which argon is conducted into the reaction chamber ad a plasma is generated in the vicinity of the target. Ions from the plasma hit the target ad detach atoms from it, part of which atoms arrive at the slice ad form a layer there. In a later stage of manufacture of the semiconductor device, the slice is subdivided into a number of separate semiconductor bodies. During the sputter deposition process the atoms detached from the target arrive not only on the slice but also on components of the reaction chamber situated near the slice. A layer is accordingly also deposited on these chamber components. When the process is repeated, layers being deposited on other slices, the layer on the chamber components of the reaction chamber increases in thickness. If pure tungsten is deposited, a layer is formed on the chamber components which has a bad adhesion thereto. When the pure tungsten layer on the chamber components has reached a thickess of approximately 20 am, tungsten particles flake off from this layer ad may then end up on the surface of the slice which happens to be present in the reaction chamber at that moment. Such comparatively large particles are undesirable there. The reaction chamber, therefore, must be cleaned before the layer on the chamber components has reached this critical thickness. The addition of 10 to 30 at. % titanium to the layer achieves that the layer has a much better adhesion to the reaction chamber components id does not start flaking off in practice until it has reached a thickness of approximately 300 am. This means that the reaction chamber need not be cleaned so often, which is of great practical advantage.

US-PS 5,019,234 discloses a semiconductor device of the kind mentioned in the opening paragraph in which a intermediate layer for improving the barrier properties is formed in that the TiW barrier layer is exposed to air for some time before a layer of aluminium is deposited.

The use of the gown intermediate layer for improving the barrier properties has the disadvantage that, if the exposure to the air is to result in a practical improvement of the barrier properties, this exposure must last for a few days. The duration of the manufacturing process of the semiconductor device is in fact prolonged by the same period of a few days by this. In addition, exposure to the air has the disadvantage that deposition of the barrier layer and the layer of aluminium to be deposited thereon cannot be carried out in a modern multiple-chamber deposition device. In such a device, a semiconductor slice is transported from one deposition chamber to the other at low pressure, one layer being deposited in each chamber. Sometimes there is a extra chamber, for example, for carrying out an etching treatment. In such a device, for example, the surface of the slice may first be cleaned by etching, then a barrier layer of TiW may be deposited, ad finally a layer of aluminium, without the vacuum in the device being broken.

The invention has for its object inter alia to counteract the said disadvantages. According to the invention, the semiconductor device of the kind mentioned in the opening paragraph is for this purpose characterized in that the intermediate layer for improving the barrier properties is a layer of TiW which comprises nitrogen.

The intermediate layer of TiW comprising nitrogen - referred to as TiWN hereinafter for short - may be deposited by means of a usual sputter deposition process in the same deposition chamber immediately after deposition of the TiW layer in that nitrogen is added to the argon in which the plasma is generated. The duration of the production process is practically not prolonged by this, while the deposition of the layer package in which the conductor pattern is formed can be carried out in a multiple-chamber deposition device.

It is found that a TiW barrier layer combined with a intermediate layer of TiWN for improving the barrier properties exhibits better barrier properties than a barrier layer of TiW which has been exposed to air.

This was ascertained by means of experiments in which layers were deposited on several silicon slices provided with a layer of silicon oxide in a multiple-chamber deposition device as described above. On some slices, a layer of TiW, a layer of TiWN, ad a layer of aluminium were deposited in that order without breaking the vacuum. These slices were compared with slices on which the known TiW barrier layer was deposited, after which these slices were exposed to air, after which a aluminium layer was deposited. In the experiments, the silicon slices were heated in vacuum at a temperature of 450 C for some time after the deposition of the aluminium layer. The electrical square resistance of the aluminium layer was measured during this. Since chemical compounds arising from reactions of titanium and tungsten with aluminium have a electrical resistance which is much greater than that of aluminium, the measured resistance increases as aluminium is consumed for forming these compounds. This aluminium consumption is much smaller with the use of the barrier layers according to the invention than with the use of the described known barrier layer which has been exposed to air for a prolonged period; aluminium practically fails to react with Ti ad W in the former case. Such reactions are prevented because a layer comprising AI and N of 1 to 3nm thickness is formed at the interface of the TiWN layer and the aluminium layer during the heat treatment at 450 _{°} C. This layer comprising AI and N constitutes a barrier to the said reactions and further ensures that aluminium has a very good adhesion to the TiWN intermediate layer. The layer comprising AI ad N is so thin that the resistance of the aluminium layer substantially does not increase thanks to the low aluminium consumption in the formation of this layer.

An aluminium consumption which is much smaller than that occurring with the use of a TiW barrier layer exposed to air is obtained when the aluminium layer is deposited on a intermediate layer of TiWN for improving the barrier properties which comprises 15 to 40 at. % nitrogen. Preferably, a intermediate layer of TiWN is used which comprises 30 to 40 at. % N. The aluminium consumption is very low then. A TiWN layer which comprises well over 40 at. % N, such as, for example, 50 at. %, is not suitable as a intermediate layer because nitrogen is evolved from the layer during the subsequent heat treatments. This tends to break the adhesion between the aluminium layer deposited on the intermediate layer and the intermediate layer. Such a delamination is not observed when TiWN layers comprising 40 at. % or less N are used.

The combination of the TiW barrier layer and the TiWN intermediate layer improving the barrier properties according to the invention not only possesses the said good barrier properties, but is also found to lead to a practical sputter deposition process. It is of major importance for a practical sputter deposition process, as described above, that layers ending up on components situated in the reaction chamber in the vicinity of the slice have good adhesion to these chamber components and to one another. If a thick layer can be deposited on these components without particles flaking off from this layer, the deposition device accordingly need not be cleaned often. It is found that TiW adheres well to these chamber components. TiW in addition ensures that the TiW and TiWN layers deposited consecutively on these components have good mutual adhesion. If the TiW layer were to be left out, the TiWN layer in itself would indeed form a satisfactory barrier between silicon and aluminium, but the desired adhesion to the chamber components would not be obtained. In this case the layer would already start flaking off from the chamber components at a thickness of less than 5 /1.m. The material from which the chamber components are manufactured plays no part in practice. Such a bad adhesion is also found when aluminium is used. The compounds comprising AI ad N mentioned above, which strongly improve the adhesion between AI ad TiWN, are not formed because the chamber components do not reach the said high temperatures.

Preferably, the TiW barrier layer has a thickness which is 2 to 5 times the thickness of the intermediate layer for improving the barrier properties. Thus an approximately 300µm thick layer can be deposited on the said chamber components before undesirable particles start flaking off therefrom.

More in particular, the TiW barrier layer has a thickness of 60 to 100 nm and the intermediate layer for improving the barrier properties has a thickness of 10 to 30 nm. In that case the barrier properties of the combination according to the invention of a TiW layer ad a TiWN intermediate layer are optimal, while these layers can also be readily deposited in practice.

The invention is explained in more detail below by way of example with reference to a drawing and a few embodiments. In the drawing
Figs. 1 to 3 diagrammatically ad in cross-section show a few stages in the manufacture of the semiconductor device according to the invention,
Fig. 4 diagrammatically shows a multiple-chamber deposition device for carrying out the method according to the invention,
Fig. 5 diagrammatically shows one of the reaction chambers of the device shown in Fig. 4, and
Fig. 6 shows the consumption C in nm of aluminium layers deposited on different barrier layers as a function of time in minutes during a heat treatment at 450 _{°} C.

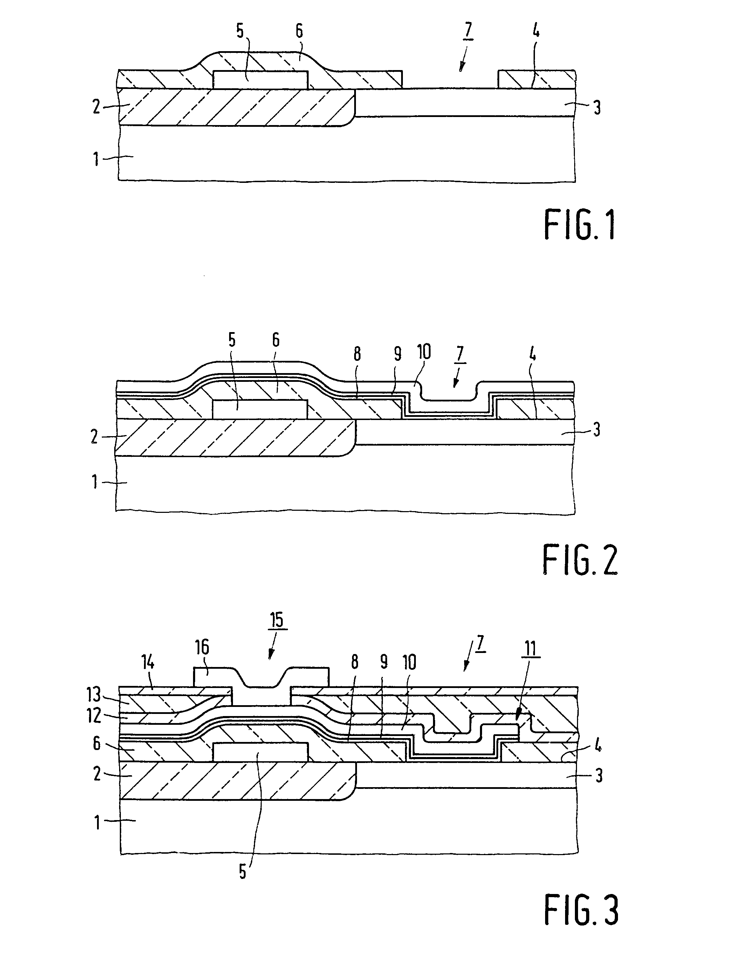

Figs. 1 to 3 diagrammatically ad in cross-section show a few stages in the manufacture of a semiconductor device with a semiconductor body 1 of, for example, n-type doped monocrystalline silicon in which field oxide regions 2 and p-type doped semiconductor zones 3 adjoining the surface 4 are provided in usual manner. Conductor tracks 5 of polycrystalline silicon are provided on the surface 4. After that, the surface 4 is provided with an insulating layer 6 of, for example, silicon oxide, silicon nitride, or silicon oxynitride. Windows 7 are provided in the insulating layer 6 for contacting silicon regions situated below the insulating layer 6. These silicon regions may be regions of monocrystalline silicon, such as the semiconductor zones 3, or of polycrystalline silicon, which may or may not be provided with a top layer of a metal silicide. The Figures only show contact windows 7 which expose the semiconductor zones 3, but it will be obvious that, for example, also the conductors 5 could be exposed by means of such contact windows.

A layer package 8, 9, 10 is subsequently provided on the insulating layer 6 and in the contact window 7, with a barrier layer 8 of TiW comprising 10 to 30 at. % Ti, an intermediate layer 9 improving the barrier properties, and a top layer 10 comprising aluminium. The top layer 10 may be of pure aluminium, but alternatively up to a few percents of silicon and copper may be added to this layer.

According to the invention, the intermediate layer 9 improving the barrier properties is a layer of TiW which comprises nitrogen. This intermediate layer 9 of TiW comprising nitrogen - referred to hereinafter as TiWN for short - may be deposited by means of a usual sputter deposition process immediately after deposition of the TiW layer in the same deposition chamber in that nitrogen is added to the argon in which the plasma is generated. The duration of the production process is practically not prolonged by this, while the deposition of the layer package 8, 9, 10 in which the conductor pattern 11 is formed can be carried out in a multiple-chamber deposition device. It will become apparent below that a TiW barrier layer 8 combined with a TiWN intermediate layer 9 improving the barrier properties exhibits better barrier properties than a barrier layer of TiW which has been exposed to air.

After a pattern of conductors 11 has been etched in the layer package 8, 9, 10 in usual manner, which conductors are connected to the semiconductor zones 3 through contact windows 7, a package of insulating layers 12, 13, 14 is provided in that order. A layer of silicon oxide 12 is provided by means of a plasma deposition process (PECVD), a layer 13 of spin-on glass (SOG) is provided by means of a spin-on method, and then a layer of silicon oxide 14 is provided by means of a plasma deposition process (PECVD) again. Contact windows 15 are provided in the layer package 12, 13, 14, so that a conductor pattern 16 provided on the package makes contact with the aluminium top layer 10. Since the use of the layer of spin-on glass 13 in the layer package 12, 13, 14 has a smoothing effect, the upper silicon oxide layer 14 is comparatively plane.

The TiW barrier layer 8 and the intermediate layer 11 are used to ensure that the aluminium layer 10 adheres well to the insulating layer 6 and to ensure that interactions between the silicon of the semiconductor zones 3 and the aluminium of the conductor tracks 10 provided on the surface are counteracted. Such interactions could occur during the subsequent manufacture of the semiconductor device during which the semiconductor body is heated several more times up to a relatively high temperature. During the deposition of the silicon oxide layer 12, the semiconductor body 1 is heated at 300 _{°} C for approximately 10 minutes, after the deposition of the spin-on glass layer 13 for approximately 40 minutes at 425 C for densifying the layer, and during the deposition of the silicon oxide layer 14 for approximately 10 minutes at 300 C again. After the conductor pattern 15 has been provided, during which the semiconductor body 1 reaches a temperature of approximately 200 _{°} C, a additional silicon oxide layer and a silicon nitride layer are deposited (both not shown). During these deposition processes the semiconductor body is at a temperature of 300 _{°} C for approximately 30 minutes. Finally, a final heat treatment is carried out for approximately 20 minutes at a temperature of 425 _{°} C. Aluminium practically does not react with Ti and W from the barrier layer during heat treatments at a temperature of 300 C or below, this occurs mainly during the treatments at temperatures above 400° C. Only the heat treatments above 400 _{°} C are of practical importance for the said chemical reactions, in the present example a total of 60 minutes at a temperature of 425° C.

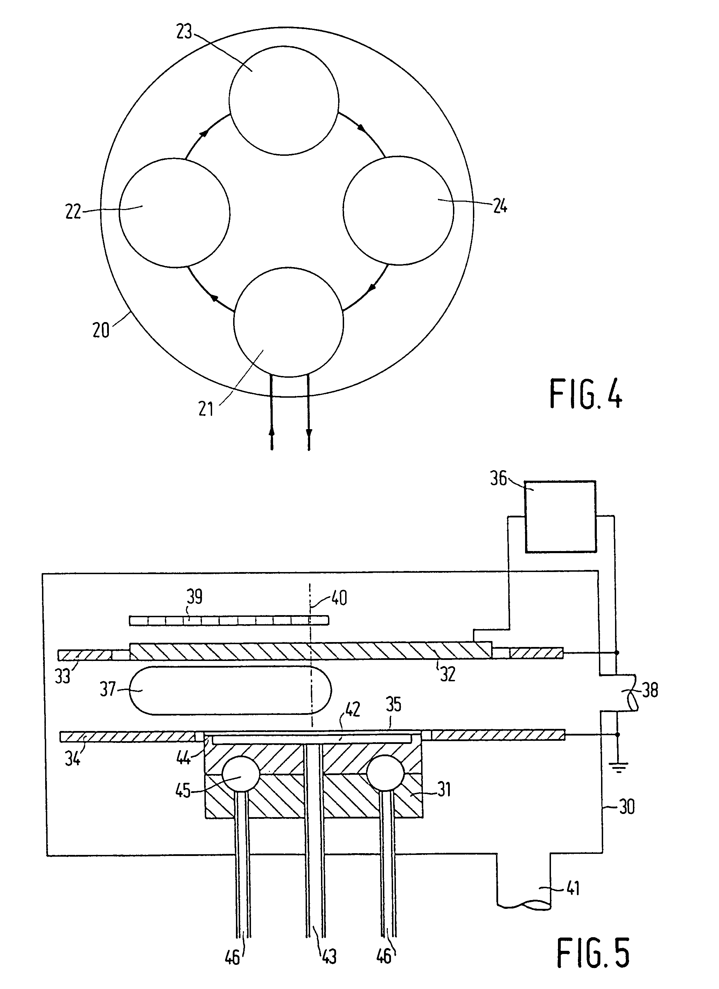

Fig. 4 diagrammatically shows a multiple-chamber deposition device suitable for depositing the layer package 8, 9, 10. This device comprises a vacuumtight housing 20 within which four chambers 21, 22, 23, 24 are arranged in the present example. Semiconductor slices can be transported from one chamber to the other, as indicated diagrammatically with arrows, inside the housing 20 under vacuum. The semiconductor slices can be inserted into and taken from the housing 20 through a first chamber 21, the so-called load lock. In the second chamber 22, for example, the slices are subjected to a usual sputter etching treatment to clean the slice surface. In the third chamber 23, the barrier layer 8 and the intermediate layer 9 are deposited, and the aluminium layer 10 is deposited in the fourth chamber 24. Finally, the slices are taken from the housing 20 through the first chamber 21 again. The slices then comprise a large number of semiconductor devices in a finishing stage as shown in Fig. 2. In a later stage of manufacture of the semiconductor device, the slices are subdivided into a number of separate semiconductor bodies 1.

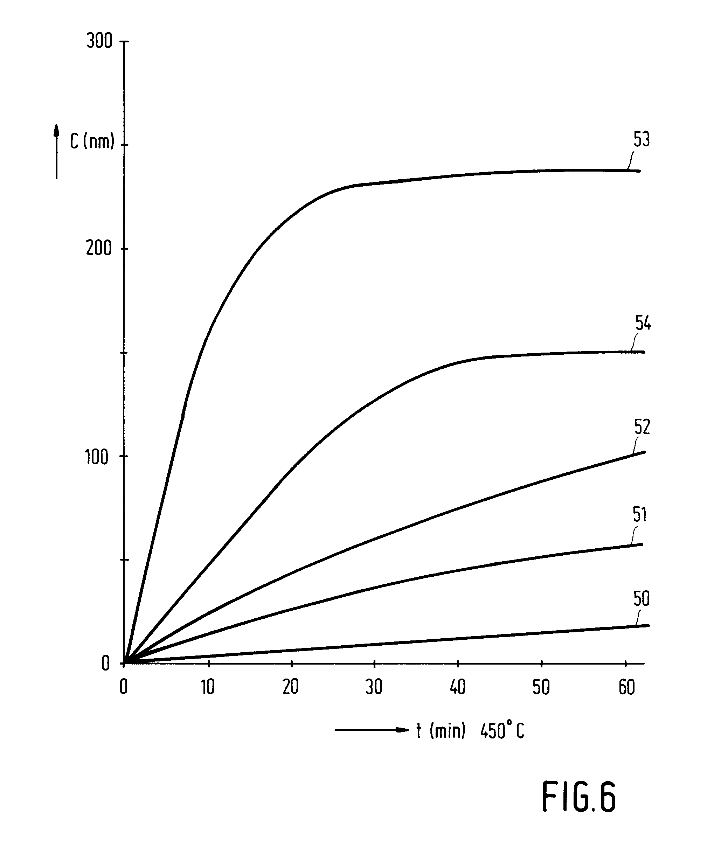

Fig. 5 diagrammatically shows one of the deposition chambers of the multiple-chamber deposition device. A support 31 is arranged parallel to a plane target 32 and to a flat earthed conductive ring 33 surrounding the target 32 in the reaction chamber 30. An earthed screen 34 is provided around the support. A slice of semiconductor material 35 is placed on the support 31, after which argon is led into the reaction chamber. A usual DC voltage source 36 is connected between the target 32 and the conductive ring 33 surrounding the target 32, whereby a plasma is generated at a voltage of 300 to 700 V, which plasma is confined between the target 32 and the slice 35 and in a space 37 close to the target 32 by means of magnets 39 arranged behind the target. The argon is fed into the reaction chamber 30 through a gass inlet 38.

The magnets 39 can rotate together about an axis 40. In practice, they rotate a few times every second about the axis 40 during the deposition process, so that the plasma ad the space 37 in which it is confined are rotated about the same axis 40. This achieves that atoms are sputtered off the entire surface of the target 32 homogeneously and that also a homogeneous deposition on the entire slice 35 is obtained.

The slice 35 is cooled during the deposition in that a gas cushion 42 with a pressure of 100 to 2000 Pa is maintained between the support 31 and the semiconductor slice 35. Argon gas is conducted to between the support 31 and the slice 35 through a gas line 43. The support 31 is provided with a rim 44 against which the slice 35 is pressed by clamps (not shown). Leakage of argon gas from the gas cushion 42 into the reactor chamber 30 is limited by this. The support 31 is cooled with cooling water which flows through lines 46 into a channel 45 provided in the support 31.

The chamber 30 is further provided with a gas outlet 41 which is connected to a pump (not shown) by which gases can be discharged and by which the reaction chamber 30 can be kept at a desired pressure.

In the experiments to be described below, layers were deposited on several silicon slices provided with a silicon oxide layer in the multiple-chamber deposition device 20 described above. An approximately 80 nm thick TiW layer, a approximately 20 nm thick TiWN layer and an approximately 500 nm thick aluminium layer were deposited in that order on a number of slices without breaking the vacuum, the TiWN layer comprising 35 at.%, 20 at.% or 10 at.% N. An approximately 100 nm thick barrier layer of TiW was deposited on other slices, upon which these slices were exposed to air for some time ad an approximately 500 nm thick aluminium layer was deposited.

The layers were deposited in the reaction chamber described above. For the deposition of the TiW layers, 22 scc argon per minute was conducted into the reaction chamber at a pressure of approximately 0,8 Pa ad a power of 4 kW was supplied to the plasma. For the deposition of the TiWN layers, a gas mixture of 22 scc argon and 12 scc nitrogen per minute was conducted into the reaction chamber at a pressure of approximately 0,8 Pa and a power of 1, 2 or 4 kW was supplied to the plasma, so that a TiWN layer with 35 at.%, 20 at.% and 10 at.% nitrogen, respectively, was obtained. For the deposition of the aluminium layer, 22 scc argon per minute was conducted into the reaction chamber at a pressure of approximately 0,8 Pa and a power of 10 kW was supplied to the plasma.

All slices were heated for some time in vacuum to a temperature of 450 _{°} C after deposition of the aluminium layer. The electrical square resistance of the aluminium layer was measured during this. Since chemical compounds arising from reactions of titanium and tungsten with aluminium have an electrical resistance which is much greater than that of aluminium, the measured resistance increases as aluminium is consumed for forming these compounds.

Fig. 6 shows the consumption C in nm of aluminium layers deposited on different barrier layers as a function of time in minutes during heating at 450 C. The lines 50, 51 and 52 show the aluminium consumption of a layer of aluminium deposited on a TiWN layer with 35 at.%, 20 at.% and 10 at.% N, respectively. The lines 53 and 54 show the aluminium consumption of an aluminium layer which was deposited on a TiW layer which had been exposed to air after deposition for 60 minutes and for a few days, respectively.

It is apparent that the aluminium consumption is much smaller with the use of the combination according to the invention of a TiW barrier layer 8 ad the TiWN intermediate layer 9 improving the barrier properties than with the use of the described known TiW barrier layer which has been exposed to air for a longer period. Aluminium hardly reacts with Ti and W at all in the former case. Such reactions are counteracted because a 1 to 3 nm thick layer comprising AI ad N is formed at the interface between the TiWN layer and the aluminium layer during heating at 450 C. This layer forms a barrier to such reactions ad further ensures that aluminium adheres very well to the TiWN intermediate layer. The layer comprising AI and N is so thin that the resistance of the aluminium layer practically does not increase owing to the small aluminium consumption during the formation of this layer.

An aluminium consumption which is much lower than that accompanying the use of a TiW barrier layer which was exposed to air is obtained when the aluminium layer 10 is deposited on a TiWN intermediate layer 9 improving the barrier properties which comprises 15 to 40 at. % nitrogen. Preferably, a TiWN intermediate layer 9 is used which comprises 30 to 40 at. % N. The aluminium consumption is very low then. A TiWN layer which comprises well above 40 at. % N, such as, for example, 50 at. %, is not suitable as an intermediate layer because nitrogen is evolved from the layer during the subsequent heat treatments. This is liable to break the adhesion between the aluminium layer deposited on the intermediate layer and the intermediate layer. Such a delamination was not observed with the use of TiWN layers comprising 40 at. % or less N.

The combination according to the invention of the TiW barrier layer 8 and the TiWN intermediate layer 9 improving the barrier properties possesses not only the said good barrier properties, but is also found to lead to a practical sputter deposition process. It is of major importance for a practical sputter deposition process that layers which are deposited on components such as the conductive ring 33 and the earthed screen 34 positioned in the reaction chamber 30 near the slice 35 show good adhesion to these chamber components 33 and 34 and to one another. If a thick layer can be deposited on these components 33 and 34 without particles flaking off from this layer, indeed, the deposition device need not be cleaned often. It is found that TiW has good adhesion to these chamber components 33 ad 34. TiW furthermore ensures that the TiW and TiWN layers which are consecutively deposited on these components have a good mutual adhesion. If the TiW layer were left out, the TiWN layer alone would form a sufficient barrier between silicon ad aluminium, but the desired adhesion to the chamber components would not be obtained. The layer on the chamber components would already start flaking off at a thickness of less than 5 /1.m then. The chamber components are manufactured from, for example, stainless steel or aluminium. The said bad adhesion is also obtained with the use of aluminium. The compounds comprising AI and N mentioned above, which strongly improve the adhesion between AI and TiWN, are not formed because the chamber components do not reach the said high temperatures.

The experiments described above have also been carried out for other layer thicknesses of the TiW barrier layer 8 ad the intermediate layer 9 improving the barrier properties. These showed that the TiW barrier layer 8 should preferably have a thickness which is 2 to 5 times the thickness of the intermediate layer 9 improving the barrier properties. Thus an approximately 300 /1.m thick layer can be deposited on the said chamber components 33 and 34 before undesirable particles start flaking off from it. More in particular, the TiW barrier layer 8 has a thickness of 60 to 100 nm and the intermediate layer 9 improving the barrier properties has a thickness of 10 to 30 nm. In that case the barrier properties of the combination according to the invention of TiW layer 8 and TiWN intermediate layer 9 are optimal, while in practice these layers can also be readily deposited.

## Claims

1. A semiconductor device comprising a semiconductor body with a surface provided with an insulating layer in which contact windows are provided through which silicon regions situated below the insulating layer are connected to a pattern of conductors formed in a layer package provided on the insulating layer and in the contact windows, which package comprises a barrier layer of TiW with 10 to 30 at. % Ti, a intermediate layer for improving the barrier properties, and a top layer comprising aluminium, characterized in that the intermediate layer for improving the barrier properties is a layer of TiW which comprises nitrogen.

2. A semiconductor device as claimed in Claim 1, characterized in that the intermediate layer for improving the barrier properties comprises 15 to 40 at. % nitrogen.

3. A semiconductor device as claimed in Claim 2, characterized in that the intermediate layer for improving the barrier properties comprises 30 to 40 at. % nitrogen.

4. A semiconductor device as claimed in Claim 2 or 3, characterized in that the TiW barrier layer has a thickness which is 2 to 5 times the thickness of the intermediate layer for improving the barrier properties.

5. A semiconductor device as claimed in Claim 4, characterized in that the TiW barrier layer has a thickness of 60 to 100 nm and the intermediate layer for improving the barrier properties has a thickness of 10 to 30 nm.
